# EUROPEAN PATENT APPLICATION

(11) **EP 2 487 534 A2**
(43) Date of publication of application: **15.08.2012**
(21) Application number: 10822248.0
(22) Date of filing: 07.10.2010
(51) Int. Cl.: G02F 1/13357

(54) **BACKLIGHT UNIT**

(30) Priority: 07.10.2009 KR 20090094957
(71) Applicant: Samsung LED Co., Ltd., Gyunggi-do 442-743 (KR)
(72) Inventor: AN, Ji-Young, Suwon Gyunggi-do 443- 374 (KR); SHIN, Jae-Hong, Suwon Gyunggi-do 442-150 (KR)
(74) Representative: Zimmermann & Partner
(86) International application number: PCT/KR2010/006855
(87) International publication number: WO 2011/043603

(57) **Abstract**

There is provided a backlight unit (BLU). The BLU may include: a plurality of LED modules, each LED module including a plurality of LEDs; and one or more driving drivers controlling brightness of the plurality of LEDs included in each of the plurality of LED modules, wherein at least two LED modules among the plurality of LED modules are commonly connected to one of the driving drivers in parallel.

## Description

### [Technical Field]

The present invention relates to a backlight unit used in a liquid crystal display (LCD) or the like using a light emitting device (LED), and more particularly, to a backlight unit having a reduced number of driving drivers for driving a plurality of LEDs used as a light source.

### [Background Art]

Recently, a range of applications for a liquid crystal display (LCD) having lightness, slimness, and low power consumption have increased, and with the development of a slim TV and a computer monitor provided with the LCD, a backlight unit (BLU) as a light source has also been miniaturized and thinned.

Since the LCD is not a self-light emitting display, a BLU providing light is provided on the rear surface of a liquid crystal display panel. In general, a BLU uses a cold cathode fluorescent lamp (CCFL), an external electrode fluorescent lamp (EEFL), a light emitting diode, or the like, as a light source; however, the fluorescent lamps are disadvantageous, in that they may cause environmental pollution through the use of mercury gas, have a low response speed, as well as low color reproducibility, and they may be inappropriate for the lightning, slimming, and miniaturizing of the liquid crystal display panel.

In contrast, a light emitting device (LED) may have a high response speed, on the level of several nanoseconds, and high color reproducibility, as well as advantages, such as high light efficiency, low power consumption, and ultra-slimness, and accordingly, has been actively employed as a BLU light source.

A BLU which concentrates light emitted by respective LEDs within an LED module towards a surface of a liquid crystal display panel may include a light guide panel generating excellent, uniform brightness, a prism sheet concentrating light, reflection and diffusion sheets, a mold frame, an inverter, and the like, stacked therein to transmit light to the liquid crystal display panel.

In particular, since individual LED modules need to include driving drivers, the number of driving drivers and the number of electric and electronic components configuring the same are increased, such that manufacturing costs of the BLU may be increased and the slimming thereof may be difficult to undertake, due to an increase in mounting area.

In addition, since a driving current is generated in each driving driver in order to drive the LEDs of the LED module, magnitudes of the driving currents supplied to individual LEDs may be different in respective LED modules, such that light generated in the respective LED modules may not be uniform, thereby deteriorating image quality in the liquid crystal display panel.

### [Disclosure]

### [Technical Problem]

An aspect of the present invention provides a backlight unit (BLU) capable of reducing the number of driving drivers controlling brightness of a plurality of LEDs and a size of the BLU by decreasing a voltage difference between LED modules, and capable of improving image quality by supplying a driving current having a uniform magnitude.

### [Technical Solution]

According to an aspect of the present invention, there is provided a backlight unit, including: a plurality of LED modules, each LED module including a plurality of LEDs; and one or more driving drivers controlling brightness of the plurality of LEDs included in each of the plurality of LED modules, wherein at least two LED modules among the plurality of LED modules are commonly connected to one of the driving drivers in parallel.

In addition, each LED module may include an LED array having the plurality of LEDs connected in series.

In addition, each LED module may be connected to one of the driving drivers, and each driving driver may be connected to the at least two LED modules.

In addition, a forward voltage of the plurality of LEDs may be subdivided into a plurality of sections and the LEDs having the subdivided forward voltages corresponding to the respective sections may be alternately mounted for the respective sections.

The backlight unit may further include a control unit controlling the driving drivers.

### [Advantageous Effects]

According to the embodiments of the present invention, the number of driving drivers is decreased to reduce a mounting space required therefor, such that the overall size of a backlight unit (BLU) can be reduced to contribute to the miniaturization and slimming thereof.

In addition, the number of electric and electronic components is reduced according to a decrease in the number of driving drivers, such that the degree of freedom of design can be increased, to thereby reduce manufacturing costs of the BLU.

Further, the control of the driving drivers may be facilitated, such that a voltage difference between modules can be reduced to provide a driving current having a uniform magnitude, thereby improving image quality.

### [Description of Drawings]

FIG. 1 is a plan view schematically illustrating a backlight unit (BLU) according to an embodiment of the present invention.
FIG. 2 shows perspective views illustrating embodiments of a combination of LEDs mounted in an LED module shown in FIG. 1.
FIG. 3 shows graphs illustrating LED distribution according to a forward voltage.
FIG. 4 is a plan view illustrating another embodiment of a connection structure of the LED module and a driving driver.
FIG. 5 is a plan view illustrating another embodiment of a connection structure of the LED module and the driving driver.

### [Best Mode]

A backlight unit according to embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. Thus, the shapes and sizes of components shown in the drawings are exaggerated for clarity. Elements having substantially the same or equivalent constitutions and functions are referred to by the same reference numerals throughout the specification.

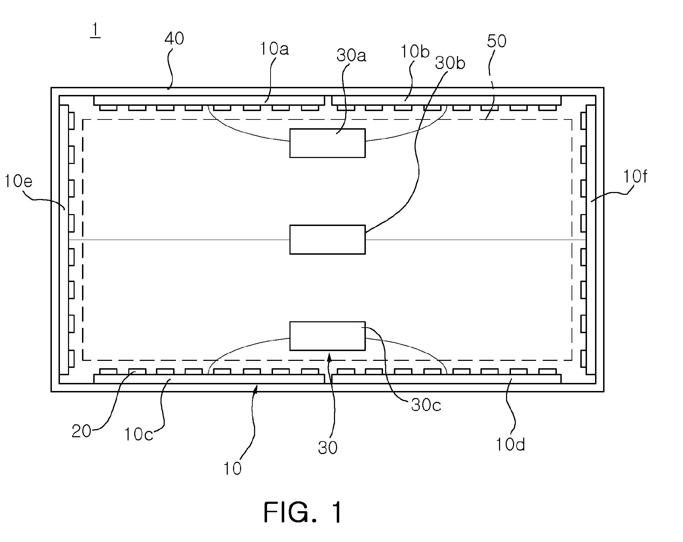

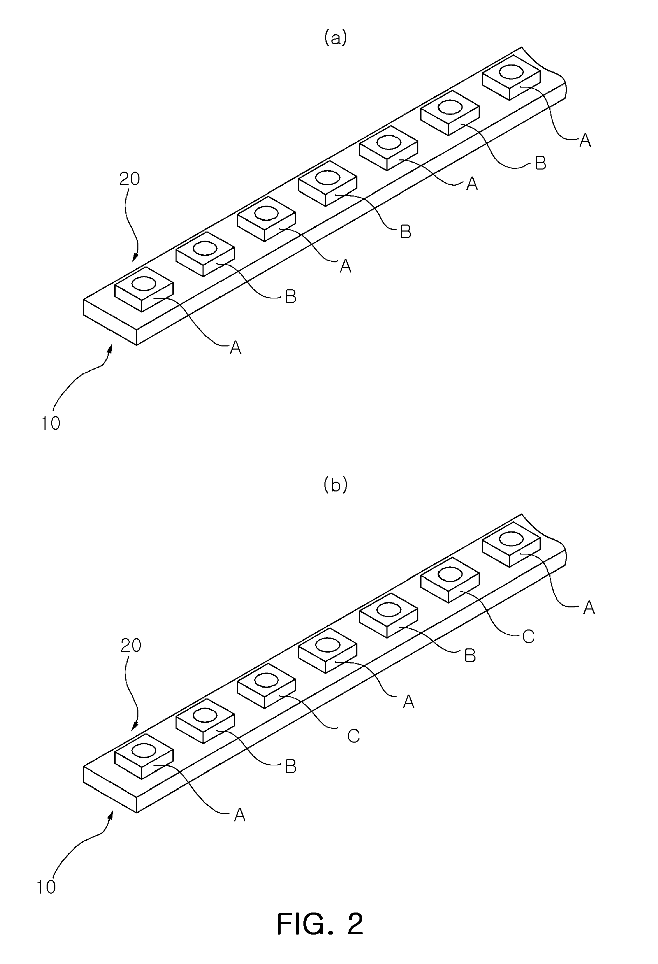

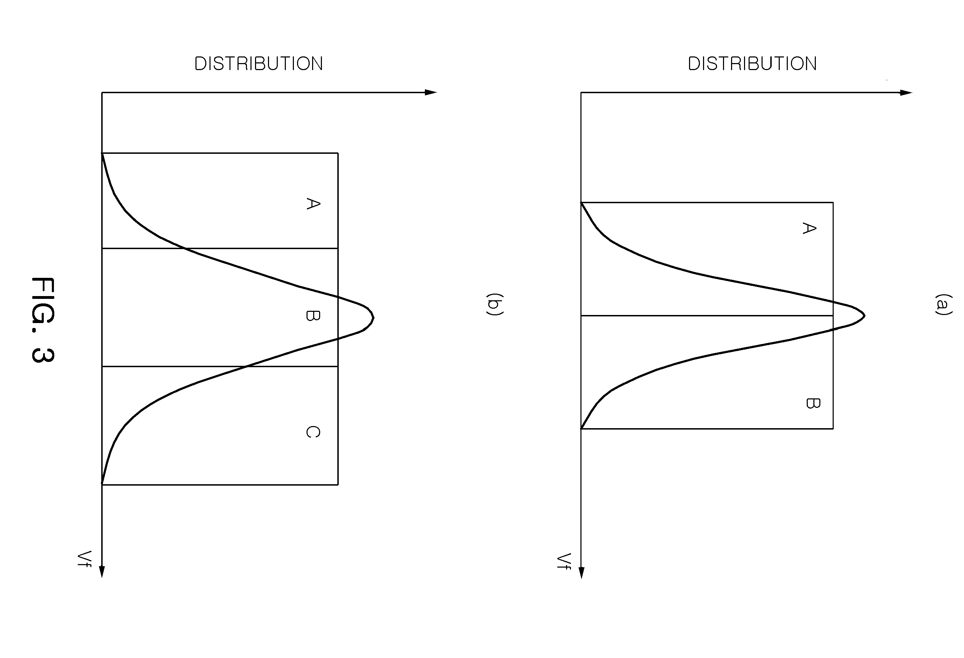

FIG. 1 is a plan view schematically illustrating a backlight unit (BLU) according to an embodiment of the present invention. FIG. 2 shows perspective views illustrating embodiments of a combination of LEDs mounted in an LED module shown in FIG. 1. FIG. 3 shows graphs illustrating LED distribution according to a forward voltage.

Referring to FIGS. 1 through 3, a backlight unit (BLU) 1, according to an embodiment of the present invention, may include a plurality of LED modules 10, each LED module including a plurality of LEDs 20, and one or more driving drivers 30 controlling brightness of the plurality of LEDs 20 included in each of the plurality of LED modules 10.

As shown in the drawings, the embodiment describes an edge scheme in which the LED modules 10, employed as a linear light source facing one surface or a plurality of surfaces of a light guide panel 50 are disposed along an inner surface of a frame 40, as being standard.

However, the present invention is not limited thereto, and a direct scheme may also be used; however, since these schemes are merely different in terms of the disposition of LED modules, a detailed description thereof will be omitted.

Each LED module 10, a unit including the plurality of LEDs 20 to emit white light and employed as a surface light source or a line light source having a certain area in itself, may include a substrate such as a submount and the plurality of LEDs 20 mounted thereon.

Here, the plurality of LEDs 20 may be white LEDs; however, the present invention is not necessarily limited thereto. Each LED 20 may be a single package including a Light Emitting Diode chip therein.

As in FIG. 2, the plurality of LEDs 20 included in each LED module 10 may be mounted on the substrate and electrically connected to one another. Here, the plurality of LEDs 20 included in each LED module 10 may form an LED array connected in series.

In the embodiment of the present invention, the LED array included in each LED module may be formed through a method of subdividing LED characteristics into predetermined sections and combining the subdivided LED characteristics.

In general, a single LED manufactured by packaging an LED chip may have characteristics, such as color coordinates, brightness, a forward voltage (V_{f}), wavelength, or the like corresponding to a certain range section, and respective characteristic values may not be identical, but slightly different in respective LEDs.

That is, color coordinate range sections and forward voltage range sections of respective LEDs are not identical, but are different in terms of upper limit values or lower limit values.

Thus, in forming an LED array by mounting the plurality of LEDs 20, when only the LEDs 20 having characteristics corresponding to a certain range section are mounted, a voltage difference (ΔV) is significantly generated between an LED module in which the LEDs 20 having a high level of forward voltage (V_{f}) are mounted and an LED module in which the LEDs 20 having a low level of forward voltage (V_{f}) are mounted, to cause defects in brightness, thereby resulting in an occurrence of spots on a display screen.

Accordingly, the forward voltage (V_{f}) of the plurality of LEDs, among the LED characteristics, is subdivided into a plurality of sections according to LED distribution, and the LEDs having the subdivided forward voltages (V_{f}) corresponding to respective sections are alternately mounted for the respective sections to form an LED array, in the embodiment of the present invention. Here, the forward voltage (V_{f}) may refer to a voltage across both ends of LED terminals connected in a forward direction.

A detailed description will be provided with reference to FIG. 3.

FIGS. 3A and 3B are graphs illustrating LED distribution according to a forward voltage.

As in FIG. 3A, in a case in which the forward voltage (V_{f}) of the LEDs 20 has a narrow range, the range of the forward voltage (V_{f}) may be subdivided into two sections (A and B).

In this case, the LEDs 20 mounted in the LED module may be classified into two types, one having a forward voltage corresponding to section A and the other having a forward voltage corresponding to section B, and the two types of LEDs 20 may be alternatively mounted in the LED module to form an LED array.

FIG. 2A illustrates an LED array combined in the order of ABAB ...; however, a combination of the LEDs 20 is not limited thereto. The LEDs 20 may be mounted to have various combinations, such as AABB, ABBA, or the like, to form an LED array.

Meanwhile, as in FIG. 3B, in a case in which the forward voltage (V_{f}) of the LEDs 20 has a broad range, the range of the forward voltage (V_{f}) may be subdivided into three sections (A, B, and C).

In this case, the LEDs 20 mounted in the LED module may be classified into three types, one having a forward voltage corresponding to section A, another having a forward voltage corresponding to section B, and another having the forward voltage corresponding to section C. The three types of LEDs 20 may be alternatively mounted in the LED module to form an LED array.

FIG. 2B illustrates an LED array combined in accordance with the order of ABCABC...; however, a combination of the LEDs 20 is not limited thereto. The LEDs 20 may be mounted to have various combinations, such as ABAC, ABBC, or the like to form an LED array.

FIGS. 2 and 3 describe that the range of the forward voltage (V_{f}) is subdivided into two or three sections. However, the present invention is not limited thereto and the range of the forward voltage (V_{f}) may be subdivided into various sections.

In this manner, the LEDs 20 having the subdivided forward voltages (V_{f}) corresponding to the respective sections are alternately mounted, such that an average forward voltage in the LED module including the LEDs 20 may be predictable and may be set to have a certain range value through a modification in distribution of the LEDs 20.

In addition, a deviation in forward voltage (V_{f}) between the LEDs 20 connected in series within the LED module is reduced to decrease the voltage difference (ΔV) between the respective LED modules 10, thereby allowing brightness to be uniform overall.

One or more driving drivers 30 may be provided to control brightness of the plurality of LEDs 20 included in each of the plurality of LED modules 10 and be electrically connected to the plurality of LED modules 10.

Although not illustrated in the drawings, the BLU 1 may include a sensor sensing light emitted from the LEDs, such that a comparison between predetermined brightness and color sense of light and sensed brightness and color sense of light may be undertaken, thereby controlling the brightness of the LEDs so as to perform compensation.

In addition, the BLU 1 may further include a control unit connected to and controlling the driving drivers 30.

As in the drawings, each LED module 10 may be connected to one of the driving drivers 30, and each driving driver 30 may be connected to at least two LED modules 10.

In this case, the LED modules 10 commonly connected to one of the driving drivers 30 may have a small voltage difference therebetween or may have substantially the same range of forward voltage.

This may be controlled through a combination of the LEDs 20 according to forward voltage subdivision for the plurality of LEDs 20 mounted in the respective LED modules 10 above mentioned.

Thus, the LED modules 10 commonly connected to one of the driving drivers 30 may have a connection structure in which they are connected in parallel.

Referring to FIG. 1, a first LED module 10a and a second LED 10b module having a small voltage difference therebetween may be connected to a first driving driver 30a to form a connection structure, a third LED module 10c and a fourth LED module 10d having a small voltage difference therebetween may be connected to a third driving driver 30c to form a connection structure, and a fifth LED module 10e and a sixth LED module 10f having a small voltage difference therebetween may be connected to a second driving driver 30b to form a connection structure.

That is, at least two LED modules 10 having a small voltage difference therebetween may be simultaneously driven by one driving driver 30 commonly connected therebetween.

In this manner, according to the embodiment, the driving drivers may be individually provided for the respective LED modules to thereby decrease the overall number of driving drivers as compared to those of a BLU according to the related art, such that the miniaturization and slimness of the overall BLU may be possible and the number of electric and electronic components required for the BLU may be reduced.

Further, in accordance with the decrease in the number of driving drivers, it may be easier to control the entire driving drivers in order to compensate for optical characteristics of the BLU, thereby allowing for improvements in image quality.

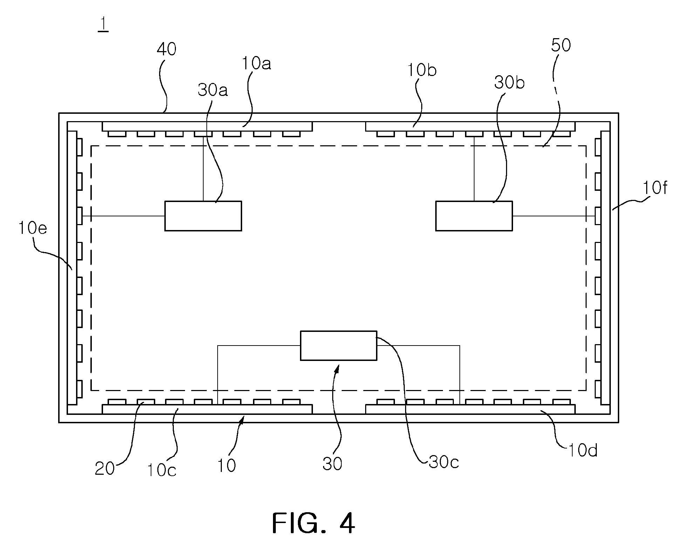

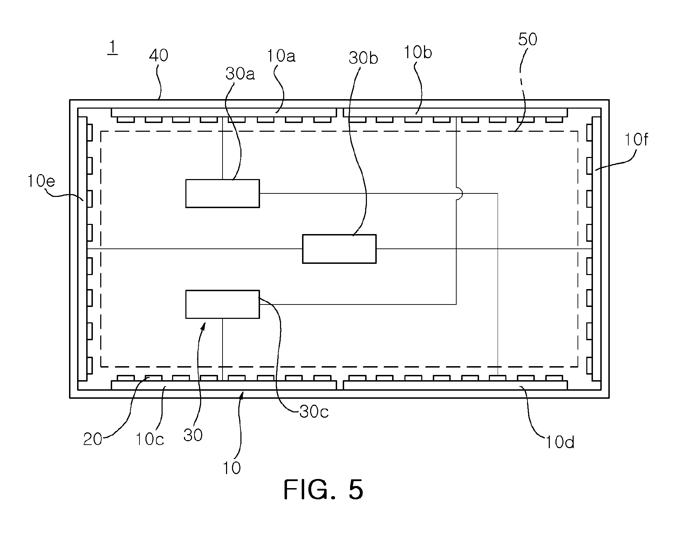

Meanwhile, FIGS. 4 and 5 illustrate various embodiments of a connection structure of the LED modules 10 and the driving drivers 30.

As in FIG. 4, the first driving driver 30a may be connected to the first LED module 10a and the fifth LED module 10e to form a connection structure, the second driving driver 30b may be connected to the second LED module 10b and the sixth LED module 10f to form a connection structure; and the third driving driver 30c may be connected to the third LED module 10c and the fourth LED module 10d to form a connection structure.

In the embodiment shown in FIG. 5, the first LED module 10a and the fourth LED module 10d may be connected to the first driving driver 30a to form a connection structure, the fifth LED module 10e and the sixth LED module 10f may be connected to the second driving driver 30b to form a connection structure; and the second LED module 10b and the third LED module 10c may be connected to the third driving driver 30c to form a connection structure.

In addition to this, the LED modules 10 electrically connected to the respective driving drivers 30 may have various connection structures, and the connection structures of the LED modules 10 are not necessarily limited thereto.

Moreover, in the plurality of LED modules 10, an electrical connection may be formed between individual LED modules, among the plurality of LED modules 10, having the driving driver 30 commonly connected therebetween, while an electrical connection may not be formed between the LED modules 10 not having the driving driver 30 commonly connected therebetween.

While the present invention has been shown and described in connection with the exemplary embodiments, it will be apparent to those skilled in the art that modifications and variations can be made without departing from the spirit and scope of the invention as defined by the appended claims.

## Claims

1. A backlight unit (BLU), comprising:
a plurality of LED modules, each LED module including a plurality of LEDs; and
one or more driving drivers controlling brightness of the plurality of LEDs included in each of the plurality of LED modules,
wherein at least two LED modules among the plurality of LED modules are commonly connected to one of the driving drivers in parallel.

2. The backlight unit (BLU) of claim 1, wherein each LED module includes an LED array having the plurality of LEDs connected in series.

3. The backlight unit (BLU) of claim 1 or 2, wherein each LED module is connected to one of the driving drivers, and each driving driver is connected to the at least two LED modules.

4. The backlight unit (BLU) of claim 1 or 2, wherein in each LED module, a forward voltage of the plurality of LEDs is subdivided into a plurality of sections and the LEDs having the subdivided forward voltages corresponding to the respective sections are alternately mounted for the respective sections.

5. The backlight unit (BLU) of claim 1, further comprising a control unit controlling the driving drivers.
